# FASCICULE DE BREVET EUROPEEN

(11) **EP 3 042 397 B1**
(45) Date de publication et mention de la délivrance du brevet: **17.05.2017**
(21) Numéro de dépôt: 14758569.9
(22) Date de dépôt: 03.09.2014
(51) Int. Cl.: H01L 31/0224

(54) **PROCEDE DE FORMATION D'UNE CELLULE PHOTOVOLTAIQUE**
VERFAHREN ZUR FORMUNG EINER PHOTOVOLTAIKZELLE
METHOD FOR FORMING A PHOTOVOLTAIC CELL

(30) Priorité: 04.09.2013 FR 1358456
(43) Date de publication de la demande: 13.07.2016
(73) Titulaire: Commissariat à l'Énergie Atomique et aux Énergies Alternatives, 75015 Paris (FR)
(72) Inventeur: BETTINELLI, Armand, F-38500 Coublevie (FR); BARBIER, Frédéric, F-38400 Saint Martin d'Heres (FR)
(74) Mandataire: Brevalex
(86) Numéro de dépôt international: PCT/EP2014/068713
(87) Numéro de publication internationale: WO 2015/032806

(56) Documents cités:
- WO-A1-2010/108151
- JP-A- 2005 101 426
- US-A1- 2008 128 268
- US-A1- 2011 100 453
- US-A1- 2011 210 428

## Description

### DOMAINE TECHNIQUE

La présente invention concerne un procédé de formation d'une cellule photovoltaïque, et plus particulièrement un procédé de formation des métallisations d'une cellule photovoltaïque.

### ÉTAT DE LA TECHNIQUE ANTÉRIEURE

Les métallisations d'une cellule photovoltaïque sont couramment réalisées par sérigraphie. Le métal habituellement utilisé pour former les métallisations est alors l'argent. Un exemple de procédé de formation d'une cellule photovoltaïque connu dans l'état de l'art est décrit dans le document US 2008/128268 A1. Un inconvénient des procédés d'impression par sérigraphie réside dans la résistivité élevée des métallisations formées.

Les méthodes d'impression par sérigraphie utilisent des pâtes à base d'argent.

Après impression, les dépôts de pâte à base d'argent sont soumis à un traitement thermique permettant au dépôt de se densifier et d'obtenir un dépôt d'argent. Dans le cas des cellules photovoltaïques à homojonction pour lesquelles le traitement thermique est effectué à une température élevée, par exemple de l'ordre de 800 °C, la résistivité des dépôts d'argent après traitement thermique est environ deux fois supérieure à celle de l'argent massif. Dans le cas des cellules photovoltaïques à hétérojonction pour lesquelles le traitement thermique est effectué à une température de l'ordre de 200 °C, la résistivité des dépôts d'argent après traitement thermique est environ quatre à cinq fois supérieure à celle de l'argent massif.

Pour réduire la résistance électrique des métallisations formées par sérigraphie sur une cellule photovoltaïque, il convient alors d'augmenter la quantité d'argent déposée sur la cellule. Il en résulte un coût de fabrication élevé d'une cellule photovoltaïque dont les métallisations sont formées par sérigraphie.

Les procédés d'impression par sérigraphie permettent de réaliser des métallisations étroites grâce notamment à l'utilisation d'écrans de sérigraphie comportant un feuillard métallique de très faible épaisseur (ou pochoirs également connus sous le nom anglo-saxon de « stencils ») et de pâtes de viscosité élevée. Des motifs de dimensions inférieures à 50 µm peuvent être obtenus. Cependant, la résistance élevée des métallisations ne permet pas la réalisation de cellules photovoltaïques performantes.

Par ailleurs, au lieu d'être formées par sérigraphie, les métallisations d'une cellule photovoltaïque peuvent être formées par dépôt électrolytique (ou électrodépôt).

Un avantage des procédés de dépôt électrolytique réside dans le fait qu'ils permettent d'obtenir des dépôts d'argent de résistivité proche de celle de l'argent massif. Il en résulte que la quantité d'argent à déposer par dépôt électrolytique est nettement inférieure à celle qui serait déposée par sérigraphie pour obtenir la même résistance électrique des métallisations. Un procédé de dépôt électrolytique permet de déposer environ deux fois moins de métal pour les cellules à homojonction et environ quatre à cinq fois moins de métal pour les cellules à hétérojonction, par rapport à un procédé de sérigraphie.

Un autre avantage des procédés de dépôt électrolytique réside dans le fait que les métallisations peuvent être réalisées en un métal autre que l'argent, par exemple en cuivre. Le cuivre présentant une résistivité proche de celle de l'argent tout en étant moins coûteux, il en résulte une réduction du coût de fabrication des cellules photovoltaïques.

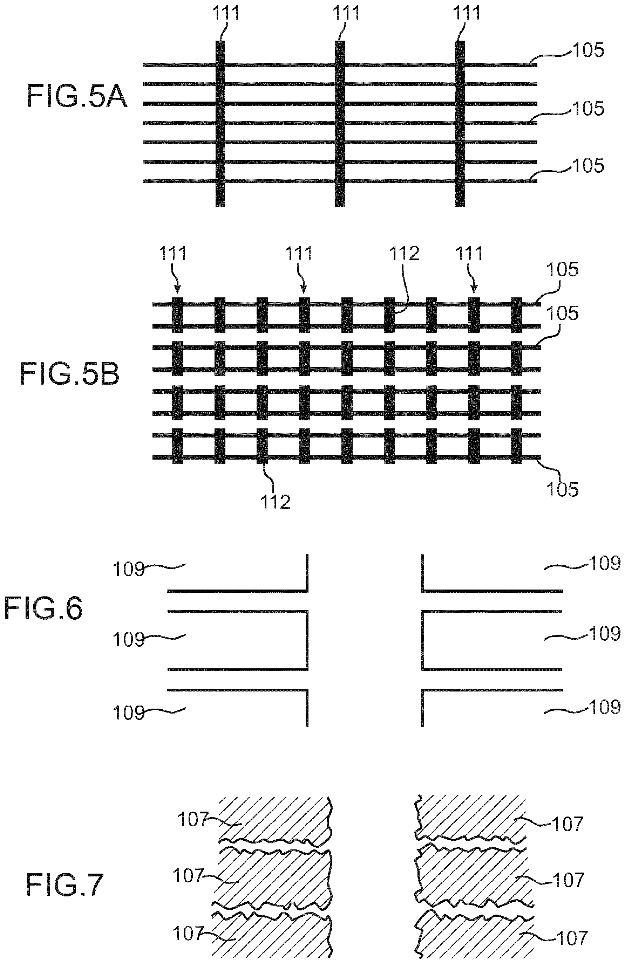

La figure 5A est une vue de dessus illustrant de façon schématique un exemple de réalisation de métallisations d'une cellule photovoltaïque.

Des motifs conducteurs 105, appelés « doigts », forment des lignes étroites, parallèles les unes aux autres et espacées les unes des autres à intervalle régulier. Des motifs conducteurs 111, appelés « bus-bars » (terme anglo-saxon) ou « barres omnibus », forment des lignes plus larges que les doigts 105 et qui sont orientées perpendiculairement aux doigts 105. Les bus-bars 111 forment des lignes parallèles les unes aux autres et espacées les unes des autres à intervalle régulier. L'exposition d'une cellule photovoltaïque à la lumière provoque la formation de charges électriques dans toutes les zones exposées de la cellule. Les doigts 105 sont destinés à transporter ces charges électriques de là où elles ont été créées vers les bus-bars. Les bus-bars 111 sont destinés à recevoir des rubans de cuivre (ou des fils), qui sont soit soudés soit collés aux bus-bars et permettent de transporter le courant d'une cellule à l'autre et de connecter les cellules entre elles. Les cellules ainsi interconnectées sont encapsulées pour former un module photovoltaïque.

Dans le cas des cellules photovoltaïques à hétérojonction, une couche conductrice optiquement transparente est préalablement formée sur la face avant des cellules avant la formation des métallisations. Pour former les métallisations de telles cellules par dépôt électrolytique, il convient alors de protéger les zones de la couche conductrice transparente sur lesquelles on ne veut pas former de métal. Pour cela, des motifs en un matériau isolant sont préalablement formés sur la couche conductrice transparente.

Les motifs de matériau isolant pourraient être formés par photolithographie. Cependant, de tels procédés sont coûteux et donc difficilement utilisables au cours d'un procédé de fabrication de cellules photovoltaïques.

Une solution consiste à utiliser un laser pour former les motifs de matériau isolant. Pour cela, on forme une couche isolante recouvrant entièrement la face avant de la cellule photovoltaïque et on utilise ensuite un laser pour éliminer des portions de la couche isolante afin de former les motifs souhaités. Cependant, dans le cas où on choisit une couche isolante optiquement transparente afin de pouvoir la conserver à la fin du procédé de fabrication de la cellule photovoltaïque, il est difficile de réaliser les motifs sans endommager la couche conductrice transparente sous-jacente, car la couche à éliminer est optiquement transparente tout comme la couche d'arrêt. Dans le cas d'une couche isolante non transparente, bien que le faisceau laser soit en partie absorbé par la couche isolante, il est également difficile d'éliminer entièrement le matériau isolant dans les zones souhaitées sans endommager la couche conductrice transparente sous-jacente.

En outre, un inconvénient des procédés de dépôt électrolytique réside dans la faible adhérence des métallisations formées.

Dans le cas des cellules à homojonction, une solution pour améliorer l'adhérence des métallisations sur les faces de l'empilement de couches semi-conductrices constituant la cellule photovoltaïque consiste à former une sous-couche d'adhérence, par exemple en siliciure de nickel, avant de réaliser les métallisations.

Cependant, il existe un compromis difficile à satisfaire pour trouver les conditions de formation d'un siliciure métallique présentant une adhérence élevée tout en évitant des court-circuits.

Dans le cas des cellules à hétérojonction, l'adhérence des métallisations formées par dépôt électrolytique sur une couche conductrice transparente est encore plus faible que dans le cas où elles sont formées sur une couche semi-conductrice. En outre, il est difficile de former une sous-couche d'adhérence en un siliciure métallique car les siliciures métalliques sont formés à des températures nettement supérieures aux températures supportées par les cellules à hétérojonction.

Il se pose donc le problème de réaliser des métallisations d'une cellule photovoltaïque présentant une faible résistivité et une adhérence élevée.

Il se pose également le problème de réaliser des métallisations d'une cellule photovoltaïque par un procédé présentant un coût réduit.

### EXPOSÉ DE L'INVENTION

La présente invention vise notamment à résoudre ces problèmes.

Du fait des difficultés présentées ci-dessus pour former des motifs de matériau isolant sur une couche conductrice transparente dans le cas des cellules à hétérojonction, les inventeurs ont également cherché à former des motifs de matériau isolant par un procédé autre que la photolithographie et le laser. Ils ont alors cherché à utiliser une technique d'impression comme la sérigraphie pour former des motifs de matériau isolant et ont identifié certains problèmes.

En effet, les faibles viscosités requises pour des dépôts de grande surface entraînent des pertes de définition des motifs imprimés en matériau isolant.

La figure 6 est une vue de dessus illustrant de façon schématique des motifs 109 d'un écran de sérigraphie pouvant être utilisé pour former des motifs de matériau isolant, par exemple sur couche conductrice transparente.

La figure 7 est une vue de dessus illustrant de façon schématique des motifs isolants 107 imprimés par sérigraphie en utilisant l'écran de sérigraphie de la figure 6.

Comme cela est visible en figure 7, des étalements d'ampleur irrégulière se produisent sur les bords des motifs 107 conduisant à des fluctuations élevées des dimensions des ouvertures. Les fluctuations des dimensions des ouvertures augmentent au fur et à mesure des impressions. On peut éviter que les dimensions des ouvertures ne se réduisent au fur et à mesure des impressions en réalisant des nettoyages réguliers de la surface de l'écran de sérigraphie mais cela n'élimine pas les irrégularités des bords des motifs. Ainsi, même avec un nettoyage régulier de l'écran de sérigraphie, il est difficile de réaliser de façon reproductible des ouvertures de dimensions de l'ordre de 50 µm.

Un objet de la présente invention vise en outre à résoudre ces problèmes.

La présente invention concerne un procédé de formation d'une cellule photovoltaïque comportant un empilement d'au moins deux couches semi-conductrices dopées selon des types de conductivité opposés, comprenant les étapes suivantes :
a) former des premiers motifs en un premier matériau conducteur par impression sur au moins une des faces de l'empilement ;
b) former des deuxièmes motifs en un matériau isolant, par impression sur ladite au moins une des faces de l'empilement, de sorte que le matériau isolant soit en contact avec au moins une partie des surfaces latérales des premiers motifs et de sorte que l'épaisseur des deuxièmes motifs soit inférieure à celle des premiers motifs ; et
c) former au moins un deuxième matériau conducteur par dépôt électrolytique sur au moins les premiers motifs.

Un avantage d'un procédé de formation de métallisations d'une cellule photovoltaïque du type de celui décrit ci-dessus est lié au fait qu'il utilise l'adhérence élevée des premiers motifs conducteurs préalablement formés par impression lors de l'étape a) et la faible résistivité de la majeure partie des métallisations formée par dépôt électrolytique lors de l'étape c).

Il en résulte une faible résistivité des métallisations formées.

En outre, comme seulement une partie des métallisations est formée par impression, il en résulte un coût de fabrication réduit des cellules photovoltaïques.

Un autre avantage d'un procédé du type de celui décrit ci-dessus est lié au fait que l'épaisseur des deuxièmes motifs isolants est choisie de sorte à être inférieure à celle des premiers motifs conducteurs. Ceci permet de former le deuxième matériau conducteur par dépôt électrolytique non seulement sur la surface supérieure des premiers motifs conducteurs mais également sur les portions des surfaces latérales des premiers motifs conducteurs qui ne sont pas en contact avec les deuxièmes motifs isolants. Il en résulte une augmentation de l'adhérence du deuxième matériau conducteur sur les premiers motifs conducteurs, par rapport au cas où le deuxième matériau conducteur se formerait seulement sur la surface supérieure des premiers motifs conducteurs.

Un autre avantage d'un procédé du type de celui décrit ci-dessus réside dans le fait que les deuxièmes motifs isolants formés lors de l'étape b), avant l'étape c) de dépôt électrolytique, peuvent être conservés après cette étape, jusqu'à la fin du procédé de fabrication de la cellule photovoltaïque et même après la mise en module des cellules photovoltaïques.

Selon un mode de réalisation de la présente invention, le procédé comprend en outre, après l'étape c) de dépôt électrolytique, une étape d) d'élimination des deuxièmes motifs isolants.

Selon un mode de réalisation de la présente invention, lors de l'étape a), les premiers motifs conducteurs sont formés par sérigraphie ou par une technique d'impression directe sans contact, par exemple une technique de distribution connue sous le nom anglo-saxon de « dispensing ».

Selon un mode de réalisation de la présente invention, lors de l'étape b), les deuxièmes motifs isolants sont formés par sérigraphie.

Selon une alternative, lors de l'étape b), les deuxièmes motifs isolants peuvent être formés par impression par jet d'encre.

Selon un mode de réalisation de la présente invention, le rapport de l'épaisseur des premiers motifs conducteurs sur l'épaisseur des deuxièmes motifs isolants est compris entre 1,2 et 2,5.

Selon un mode de réalisation de la présente invention, lors de l'étape a), le rapport de forme des premiers motifs conducteurs, correspondant au rapport de la hauteur sur la largeur des motifs, est supérieur à 0,5.

Le premier matériau conducteur peut être choisi dans le groupe comprenant l'argent, le cuivre et l'aluminium ou peut être un matériau comprenant un élément métallique choisi dans le groupe comprenant l'argent, le cuivre et l'aluminium.

Le matériau isolant peut être une résine organique isolante.

Le deuxième matériau conducteur peut être de l'argent ou du cuivre.

Un avantage d'un procédé du type de celui décrit ci-dessus réside dans le fait que les métallisations peuvent être réalisées en un métal autre que l'argent, par exemple en cuivre. Il en résulte une réduction du coût de fabrication des cellules photovoltaïques.

Selon un mode de réalisation de la présente invention, lors de l'étape c), on forme un empilement de plusieurs couches de matériaux conducteurs par dépôt électrolytique.

L'empilement de plusieurs couches de matériaux conducteurs peut comprendre une couche barrière recouverte d'une couche du deuxième matériau conducteur elle-même recouverte d'une couche de surface.

La couche barrière peut être en nickel. Le deuxième matériau conducteur peut être de l'argent ou du cuivre. La couche de surface peut être en argent ou en étain.

Selon un mode de réalisation de la présente invention, avant l'étape a) de formation des premiers motifs conducteurs, ladite au moins une des faces de l'empilement est recouverte d'une couche conductrice transparente.

La couche conductrice transparente peut être à base d'un oxyde transparent conducteur tel que l'ITO (« indium tin oxide », oxyde d'indium et d'étain), ou l'IO (oxyde d'indium), ou l'IWO (oxyde d'indium et de tungstène) ou le ZnO (oxyde de zinc).

Un avantage d'un procédé de formation de métallisations d'une cellule photovoltaïque du type de celui décrit ci-dessus réside dans le fait que les métallisations formées présentent une adhérence élevée sur les faces de la cellule photovoltaïque, notamment dans le cas où elles sont recouvertes d'une couche conductrice transparente. Il en résulte que les interconnexions réalisées ultérieurement entre ces métallisations et des rubans conducteurs sont de bonne qualité. Ceci permet de fabriquer des cellules photovoltaïques présentant des performances accrues. En outre, il n'est pas nécessaire de former une sous-couche d'adhérence sur les faces de la cellule photovoltaïque avant de former les métallisations.

Selon un mode de réalisation de la présente invention, avant l'étape a), la couche conductrice transparente est recouverte d'une couche d'adhérence conductrice.

Selon un mode de réalisation de la présente invention, lors de l'étape a), les premiers motifs formés par impression comprennent des lignes conductrices parallèles les unes aux autres, éventuellement espacées les unes des autres à intervalle régulier et/ou avantageusement discontinues.

Selon un mode de réalisation de la présente invention, lors de l'étape b) de formation des deuxièmes motifs, on définit des zones de bus, éventuellement orientées perpendiculairement aux premiers motifs, correspondant à des portions de ladite au moins une des faces de l'empilement non recouvertes par les deuxièmes motifs.

Selon un mode de réalisation de la présente invention, lors de l'étape a), on forme en outre des plots conducteurs par impression sur ladite au moins une des faces de l'empilement, les plots conducteurs étant disposés dans les zones de bus.

Les zones de bus peuvent être discontinues. Dans ce cas, lors de l'étape a), on forme au moins un plot conducteur dans chaque portion des zones de bus.

Selon un mode de réalisation de la présente invention, les zones de liaison des premiers motifs avec les zones de bus sont plus larges que le reste des premiers motifs.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.

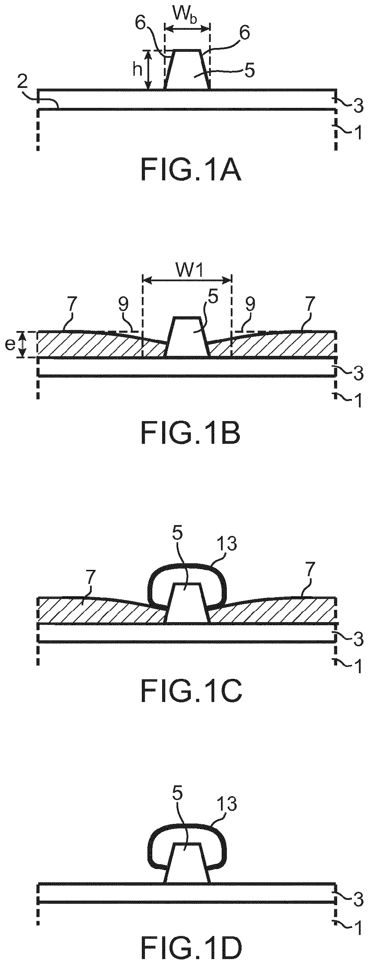

Les figures 1A à 1D sont des vues en coupe illustrant de façon schématique des étapes successives d'un procédé de formation de métallisations d'une cellule photovoltaïque selon l'invention.

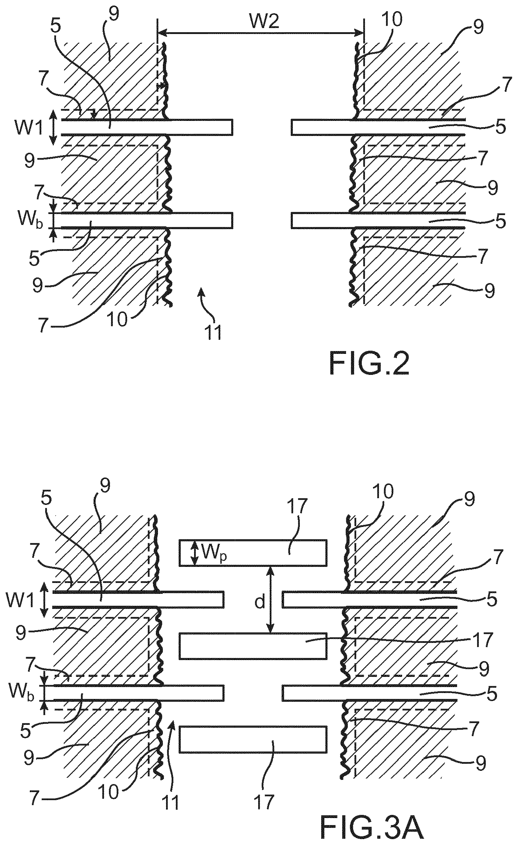

La figure 2 est une vue de dessus correspondant à la figure 1B.

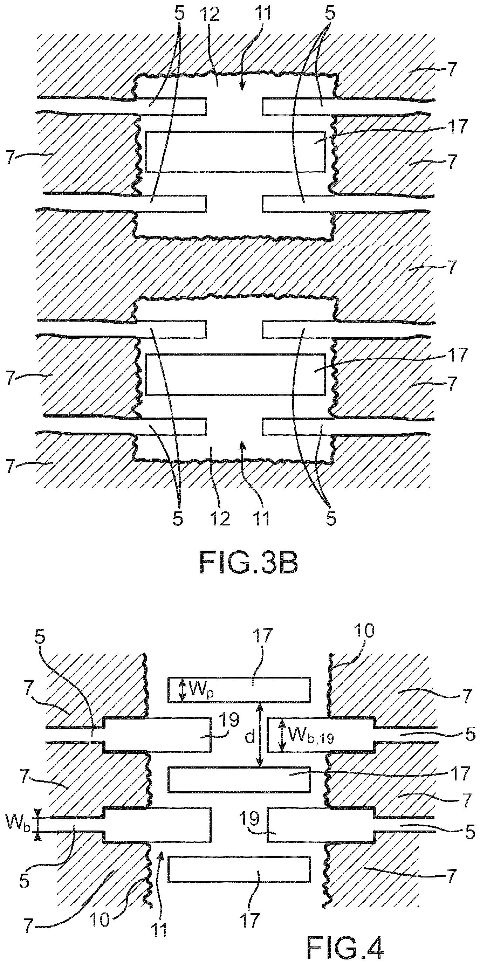

Les figures 3A et 3B sont des vues de dessus illustrant des variantes d'un procédé de formation de métallisations d'une cellule photovoltaïque selon l'invention, respectivement dans le cas de zones de bus continues et dans le cas de zones de bus discontinues.
La figure 4 est une vue de dessus illustrant une autre variante d'un procédé de formation de métallisations d'une cellule photovoltaïque selon l'invention.
Les figures 5A et 5B sont des vues de dessus illustrant de façon schématique des exemples de réalisation de métallisations d'une cellule photovoltaïque.
La figure 6 est une vue de dessus illustrant de façon schématique des motifs d'un écran de sérigraphie.
La figure 7 est une vue de dessus illustrant de façon schématique des motifs isolants imprimés par sérigraphie en utilisant l'écran de sérigraphie de la figure 6.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les inventeurs proposent, pour former les métallisations d'une cellule photovoltaïque, de former préalablement des motifs conducteurs par impression, par exemple par sérigraphie, puis de former la majeure partie des métallisations par dépôt électrolytique.

Les figures 1A à 1D sont des vues en coupe illustrant de façon schématique des étapes successives d'un procédé de formation de métallisations d'une cellule photovoltaïque. Pour des raisons de simplification, une seule des deux faces de la cellule photovoltaïque est représentée sur ces figures. Bien entendu, le procédé décrit ci-après s'applique à la formation de métallisations sur l'une et/ou l'autre des faces de la cellule photovoltaïque.

La figure 1A représente la partie supérieure 1 d'un empilement de couches semi-conductrices d'une cellule photovoltaïque. L'empilement comprend au moins deux couches semi-conductrices dopées selon des types de conductivités opposés formant une jonction PN. L'empilement comprend deux faces principales, une des deux faces seulement, la face 2, étant représentée en figure 1A. La face 2 est par exemple la face avant de la cellule photovoltaïque, c'est-à-dire la face qui est destinée à être exposée au rayonnement lumineux.

La face 2 est par exemple recouverte d'une couche conductrice transparente 3, par exemple à base d'un oxyde transparent conducteur tel que l'ITO (« indium tin oxide », oxyde d'indium et d'étain), ou l'IO (oxyde d'indium), ou l'IWO (oxyde d'indium et de tungstène) ou le ZnO (oxyde de zinc). Eventuellement, la couche conductrice transparente 3 est recouverte d'une couche d'adhérence conductrice (non représentée), par exemple une couche de titane ou d'argent ou de cuivre formée par dépôt physique en phase vapeur (PVD, « Physical Vapor Deposition »). Mais, il n'est pas nécessaire de former une sous-couche d'adhérence sur les faces de la cellule photovoltaïque avant de former les métallisations.

Des motifs 5 en un matériau conducteur sont formés sur la couche conductrice transparente 3 par un procédé d'impression, par exemple par sérigraphie. Les motifs 5 sont par exemple en argent ou en cuivre ou en aluminium, ou en un matériau comprenant un élément métallique tel que l'argent, le cuivre ou l'aluminium. Lorsque les métallisations sont réalisées en un métal autre que l'argent, par exemple en cuivre, il en résulte une réduction du coût de fabrication des cellules photovoltaïques.

Les motifs conducteurs 5 forment par exemple des lignes parallèles les unes aux autres, espacées les unes des autres à intervalle régulier et avantageusement discontinues. Dans ce cas, les motifs 5 sont appelés « doigts ». Comme cela est représenté en figure 1A, la section transversale des motifs 5, dans un plan perpendiculaire à la direction des lignes, est par exemple de forme trapézoïdale. La section des motifs 5 peut également être de forme quelconque.

Avantageusement, le rapport de forme des motifs 5, correspondant au rapport de la hauteur h sur la largeur W des motifs, est élevé. Le rapport de forme des motifs 5 est de préférence supérieur à 0,5. Dans le cas de motifs de section trapézoïdale, la largeur W des motifs est par exemple définie par la largeur de la base W_{b}. Les motifs de section trapézoïdale présentant un rapport de forme élevé ont des flancs ou surfaces latérales 6 de pente élevée.

A titre d'exemple de dimensions, pour des motifs 5 de section trapézoïdale, la largeur de la base W_{b} peut être de l'ordre de 32 µm, la largeur à mi-hauteur peut être de l'ordre 20 µm et la hauteur h peut être de l'ordre de 17 µm, ce qui correspond à un rapport de forme de l'ordre de 0,53.

Selon un autre exemple de dimensions, pour des motifs 5 de section trapézoïdale, la largeur de la base W_{b} peut être de l'ordre de 40 µm, la largeur à mi-hauteur peut être de l'ordre 25 µm et la hauteur h peut être de l'ordre de 25 µm, ce qui correspond à un rapport de forme de l'ordre de 0,62.

Dans le cas où les motifs 5 sont formés par sérigraphie, on utilisera des écrans de sérigraphie comportant un feuillard métallique de très faible épaisseur (ou pochoirs également connus sous le nom anglo-saxon de « stencils ») permettant la réalisation de motifs de facteur de forme élevé. On utilisera de préférence des stencils permettant d'obtenir des motifs 5 de section trapézoïdale.

A titre d'exemple, en utilisant des stencils d'épaisseur de l'ordre de 30 µm, comprenant des ouvertures d'environ 27 µm de largeur du côté de la face inférieure en contact avec la cellule photovoltaïque et d'environ 17 µm de largeur du côté de la face supérieure, on peut obtenir des motifs 5 de section trapézoïdale de largeur à mi-hauteur d'environ 20 µm. Des stencils encore plus fins, par exemple d'épaisseur de l'ordre de 20 µm, pourraient être utilisés pour diminuer la consommation de pâte.

Une fois les motifs 5 imprimés, un traitement thermique est effectué dans des conditions permettant d'obtenir l'adhérence et la résistivité souhaitées pour les motifs conducteurs 5.

Avantageusement, on utilisera des pâtes dites « basse température », adaptées à un traitement thermique à basse température. On utilisera par exemple des pâtes constituées d'une matrice organique, par exemple une résine de type époxy, comprenant des poudres métalliques. Ces pâtes « basse température » permettent de former des motifs conducteurs 5 présentant une adhérence élevée sur la couche conductrice transparente 3. En outre, l'adhérence des motifs 5 sur la couche conductrice transparente 3 sera conservée lors de l'étape ultérieure de dépôt électrolytique illustrée en figure 1C.

A titre d'exemple, on utilisera des pâtes « basse température » adaptées à un traitement thermique à une température de l'ordre de 200 °C. Dans le cas où la face 2 est recouverte d'une couche conductrice transparente 3 elle-même recouverte d'une couche d'adhérence oxydable, par exemple en cuivre, on choisira de préférence des pâtes adaptées à un traitement thermique à une température de l'ordre de 150 °C.

Au lieu de former les motifs conducteurs 5 par sérigraphie, d'autres procédés d'impression pourront être utilisés. Tout autre procédé d'impression permettant de former des motifs conducteurs de facteur de forme élevé et présentant une adhérence élevée pourra être utilisé pour former les motifs conducteurs 5. Des procédés d'impression directe sans contact, désignés par l'appellation « dispensing » en anglais, pourront par exemple être utilisés.

La figure 1B illustre la formation de motifs 7 en un matériau isolant sur la couche conductrice transparente 3 par un procédé d'impression, par exemple par sérigraphie. La figure 2 est une vue de dessus correspondant à la figure 1B.

Les motifs 7 peuvent être formés en un matériau isolant transparent.

Dans ce cas, les motifs isolants 7 pourront rester sur la cellule photovoltaïque à la fin du procédé de formation des métallisations. Le matériau isolant transparent peut être un matériau inorganique, par exemple du SiO₂ ou du SiN, ou un matériau organique. On choisira de préférence un matériau organique, par exemple un polymère transparent, stable et compatible avec le procédé d'encapsulation utilisé pour la mise en module des cellules photovoltaïques. Le matériau isolant 7 est par exemple une résine à base de silicone ou tout autre polymère présentant une viscosité adaptée à une impression par sérigraphie et une bonne stabilité par rapport aux rayonnements ultraviolets.

Selon une alternative, les motifs 7 peuvent être formés en un matériau isolant non transparent. Dans ce cas, les motifs isolants 7 seront éliminés après l'étape de dépôt électrolytique décrite ci-après en relation avec la figure 1C. Le matériau isolant non transparent peut être un matériau inorganique ou un matériau organique. On choisira de préférence un matériau organique, par exemple une résine.

Dans le cas où les motifs isolants 7 sont formés par sérigraphie, on utilisera un écran de sérigraphie présentant des ouvertures de largeur W1 supérieure à la largeur W_{b} de la base des motifs conducteurs 5. Les motifs de matériau isolant qui seraient obtenus sans étalement et s'ils correspondaient aux motifs définis sur l'écran de sérigraphie sont représentés par des zones 9 délimitées par des pointillés en figure 1B et en figure 2.

L'homme du métier saura choisir un matériau isolant de viscosité adaptée de sorte que, après étalement du matériau isolant, les motifs isolants 7 soient en contact avec les surfaces latérales 6 des motifs conducteurs 5, comme cela est représenté en figure 1B et en figure 2.

Les motifs conducteurs 5 formés lors de l'étape précédente ont de préférence un rapport de forme élevé, ce qui permet d'obtenir des motifs conducteurs 5 présentant des surfaces latérales 6 de pente élevée. Il en résulte que, lors de l'étalement du matériau isolant 7 (représenté par des flèches en figure 2), celui-ci s'arrête de façon nette sur les surfaces latérales des motifs conducteurs 5.

On utilisera un équipement d'impression disposant d'un système de vision compatible avec des alignements précis, ce qui est le cas des équipements actuels qui permettent des alignements à plus ou moins 15 µm près, ou mieux.

A titre d'exemple, dans le cas d'une résine de viscosité conduisant à un étalement naturel d'environ 70 µm par rapport à un bord de motif, on pourra utiliser un écran de sérigraphie présentant des ouvertures de largeur W1 de l'ordre de 120 µm. Ceci permet de tenir compte des défauts d'alignements et des irrégularités d'étalement.

Comme cela est visible en figure 2, les bords 10 des motifs isolants 7 qui ne sont pas en contact avec les motifs conducteurs 5 présentent des irrégularités.

Toutefois, ces irrégularités ne sont pas gênantes compte-tenu de la largeur W2 des zones 11 définies, appelées zones de bus. Les zones de bus 11 correspondent aux emplacements où seront formés les bus-bars. On pourrait éventuellement définir de façon plus précise les contours 10 des zones de bus 11 en formant, lors de l'étape illustrée en figure 1A, des motifs de matériau conducteur sur lesquels les bords 10 des motifs isolants 7 viendraient s'arrêter. Dans l'exemple illustré en figure 2, les motifs conducteurs 5 sont discontinus et les discontinuités des motifs conducteurs 5 se situent dans les zones de bus 11.

L'épaisseur e des motifs isolants 7 est choisie de sorte à être inférieure à l'épaisseur, ou hauteur, h des motifs conducteurs 5. Le rapport h/e entre l'épaisseur des motifs conducteurs 5 et celle des motifs isolants 7 est de préférence compris entre 1,2 et 2,5.

A titre d'exemple, l'épaisseur des motifs conducteurs 5 peut être de l'ordre de 17 µm et l'épaisseur des motifs isolants 7 peut être de l'ordre de 8 µm, ce qui correspond à un rapport h/e de l'ordre de 2,1.

Selon un autre exemple, l'épaisseur des motifs conducteurs 5 peut être de l'ordre de 25 µm et l'épaisseur des motifs isolants 7 peut être de l'ordre de 15 µm, ce qui correspond à un rapport h/e de l'ordre de 1,7.

Une fois les motifs isolants 7 imprimés, un traitement thermique est effectué. Les conditions du traitement thermique seront choisies de façon à obtenir une bonne adhérence des motifs isolants 7 sur la cellule photovoltaïque. En effet, lors de l'étape illustrée en figure 1C, la cellule photovoltaïque sera plongée dans un ou plusieurs bains de dépôt électrolytique. Les motifs isolants 7 étant destinés à protéger les zones sur lesquelles on ne veut pas former de matériau conducteur, ils doivent rester bien en place lorsque la cellule est plongée dans les bains de dépôt électrolytique. Eventuellement, les conditions du traitement thermique seront également choisies de sorte que les motifs isolants 7 puissent être éliminés après le dépôt électrolytique.

On pourra par exemple effectuer un traitement thermique à une température comprise entre environ 80 °C et environ 120 °C. Dans le cas où le matériau isolant est conservé après l'étape de dépôt électrolytique, le traitement thermique pourra être effectué à des températures plus élevées.

Au lieu de former les motifs isolants 7 par sérigraphie, d'autres procédés d'impression pourront être utilisés, par exemple des procédés d'impression par jet d'encre.

Toutefois, les procédés d'impression par jet d'encre présentent l'inconvénient d'une cadence plus réduite par rapport à la sérigraphie.

La figure 1C illustre la formation d'au moins un matériau conducteur 13 par dépôt électrolytique. Le matériau conducteur 13 est par exemple de l'argent ou du cuivre.

La cellule photovoltaïque est plongée dans un ou plusieurs bains de dépôt électrolytique.

Le matériau conducteur 13 se forme sur les portions des motifs conducteurs 5 qui ne sont pas en contact avec les motifs isolants 7. Le matériau conducteur 13 se forme également sur les portions de la couche conductrice transparente 3 qui ne sont pas recouvertes par les motifs isolants 7, et en particulier éventuellement sur les zones de bus 11 afin de former les bus-bars en même temps que les doigts. De manière plus générale, les motifs isolants 7 servent de masque lors de l'étape de dépôt électrolytique, de sorte que le matériau conducteur 13 se dépose sur les portions de la couche conductrice transparente 3 laissées libres par le masque et correspondant aux ouvertures dans ledit masque.

L'adhérence du matériau conducteur 13 formé par dépôt électrolytique sur les motifs conducteurs 5 formés par impression est élevée grâce aux liaisons métal-métal. En outre, les métallisations étant formées par dépôt électrolytique, elles auront une faible résistivité.

L'épaisseur e des motifs isolants 7 formés lors de l'étape illustrée en figure 1B a été choisie de sorte à être inférieure à l'épaisseur h des motifs conducteurs 5. Le matériau conducteur 13 se forme alors non seulement sur la surface supérieure des motifs conducteurs 5 mais également sur les portions des surfaces latérales des motifs conducteurs 5 qui ne sont pas en contact avec les motifs isolants 7. Ceci permet d'augmenter l'adhérence du matériau conducteur 13 sur les motifs conducteurs 5, par rapport au cas où le matériau conducteur 13 se formerait seulement sur la surface supérieure des motifs conducteurs 5.

Un empilement de plusieurs couches de matériaux conducteurs peut être formé par dépôt électrolytique. L'empilement de couches conductrices peut comprendre une couche barrière, par exemple en nickel, recouverte d'une couche conductrice 13 en argent ou en cuivre, elle-même recouverte d'une couche conductrice fine de surface, par exemple en argent ou en étain. La couche conductrice fine de surface est choisie de façon à obtenir des interconnexions de bonne qualité avec les rubans conducteurs formés ultérieurement pour la mise en module des cellules photovoltaïques.

L'épaisseur de la couche conductrice 13 est supérieure à celles de la couche barrière et de la couche de surface.

La figure 1D illustre l'élimination éventuelle du matériau isolant 7. Cette étape optionnelle est par exemple réalisée dans le cas où le matériau isolant 7 n'est pas transparent ou dans le cas où il n'est pas compatible avec les étapes ultérieures de mise en module des cellules photovoltaïques.

Selon une variante, les motifs isolants 7 sont conservés après l'étape de dépôt électrolytique illustrée en figure 1C. Les motifs isolants 7 peuvent être conservés jusqu'à la fin du procédé de fabrication de la cellule photovoltaïque et même après la mise en module des cellules photovoltaïques.

Bien que le procédé de formation de métallisations d'une cellule photovoltaïque illustré en figures 1A-1D ait été décrit dans le cas où une couche conductrice transparente 3 recouvre la face 2 de la cellule, le procédé s'applique à la formation de métallisations directement sur la face 2 de la cellule (éventuellement recouverte d'une couche d'adhérence conductrice).

Un avantage d'un procédé de formation de métallisations d'une cellule photovoltaïque du type de celui décrit en relation avec les figures 1A-1D est lié au fait qu'il utilise l'adhérence élevée des motifs conducteurs 5 préalablement formés par impression et la faible résistivité de la majeure partie des métallisations formée par dépôt électrolytique.

Un autre avantage d'un procédé de formation de métallisations d'une cellule photovoltaïque du type de celui décrit en relation avec les figures 1A-1D réside dans le fait que les métallisations formées présentent une adhérence élevée sur les faces de la cellule photovoltaïque, notamment dans le cas où elles sont recouvertes d'une couche conductrice transparente. Il en résulte que les interconnexions réalisées ultérieurement entre ces métallisations et des rubans conducteurs sont de bonne qualité.

Ceci permet de fabriquer des cellules photovoltaïques présentant des performances accrues.

Un autre avantage d'un procédé du type de celui décrit en relation avec les figures 1A-1D est lié au fait que seulement une partie des métallisations est formée par sérigraphie. Les bus-bars ainsi qu'une partie des doigts sont formés par dépôt électrolytique. Il en résulte un coût de fabrication réduit des cellules photovoltaïques.

Lors de l'interconnexion des rubans permettant la mise en module des cellules photovoltaïques, et lors de contraintes subies par le module photovoltaïque au cours de son utilisation, par exemple lors de dilatations différentielles dues à des variations de température, ce sont les bus-bars, sur lesquels sont réalisées les interconnexions avec les rubans de cuivre, qui sont le plus sollicités.

Afin de renforcer l'adhérence des métallisations dans les zones de bus, il est possible, lors de l'étape de formation des motifs conducteurs 5 par impression, de former également des motifs conducteurs dans ces zones de bus.

La figure 3A est une vue de dessus illustrant une telle variante du procédé de formation de métallisations d'une cellule photovoltaïque décrit en relation avec les figures 1A-1D et 2. La figure 3A, correspondant à la figure 2, représente la structure obtenue après l'étape de formation des motifs isolants 7 illustrée en figure 1B.

Lors de l'étape de formation par impression des motifs conducteurs 5 illustrée en figure 1A, des plots conducteurs 17 sont également formés dans les zones de bus 11.

Les dimensions et le nombre de plots conducteurs 17 seront choisis de façon à obtenir une adhérence suffisante du matériau conducteur 13 formé par dépôt électrolytique lors de l'étape illustrée en figure 1C, tout en minimisant la quantité de matériau conducteur utilisée. Les dimensions et le nombre de plots conducteurs 17 seront également choisis en fonction de la nature de la pâte utilisée pour l'impression et en fonction des dimensions des rubans à interconnecter.

A titre d'exemple, on pourra former, dans les zones de bus 11, des plots conducteurs 17 sous forme de lignes parallèles les unes aux autres et espacées les unes des autres à intervalle régulier. Les lignes ont par exemple une largeur Wₚ de l'ordre de 200 µm et sont par exemple espacées les unes des autres d'une distance d de l'ordre de 1 mm.

Les plots conducteurs 17 peuvent être de forme quelconque. Ils peuvent par exemple être réalisés sous forme de « S », cette forme de motifs étant bien maîtrisée par les procédés de sérigraphie par stencil.

Une fois les motifs conducteurs 5 et les plots conducteurs 17 imprimés, un traitement thermique est réalisé dans des conditions permettant d'obtenir la résistivité et l'adhérence souhaitées pour les motifs 5 et les plots 17.

Dans le cas d'une pâte conductrice en argent, le traitement thermique est par exemple effectué pendant environ 10 min à une température d'environ 200 °C.

Les plots conducteurs 17 étant formés par impression, par exemple par sérigraphie, ils présentent une adhérence élevée sur la couche conductrice transparente 3. Ils permettent ainsi d'améliorer l'adhérence du matériau conducteur 13 formé ultérieurement par dépôt électrolytique. Il en résulte une amélioration de la fiabilité des interconnexions.

La figure 4 est une vue de dessus illustrant une autre variante du procédé décrit en relation avec les figures 1A-1D. La figure 4, correspondant à la figure 2, représente la structure obtenue après l'étape de formation des motifs isolants 7 illustrée en figure 1B.

Lors de l'étape illustrée en figure 1A de formation des motifs conducteurs 5 par impression, et éventuellement de plots conducteurs 17 dans les zones de bus, au lieu de former des motifs 5 de largeur W_{b} constante, on pourra former des motifs 5 avec des géométries particulières dans les zones 19 de liaison entre les doigts 5 et les zones de bus 11. Par exemple, on pourra former des motifs conducteurs 5 dont la largeur W_{b,19} dans les zones 19 est supérieure à la largeur W_{b} du reste des motifs 5. Ceci permet de renforcer mécaniquement les doigts au voisinage des zones d'interconnexion avec les rubans tout en améliorant la conduction des charges électriques.

De façon plus générale, ce renforcement de l'adhérence des métallisations dans les zones de bus, par réalisation de motifs conducteurs par impression dans ces zones de bus, peut s'appliquer à des géométries quelconques de métallisations de cellules, et non pas uniquement aux motifs usuels en forme de « H » décrits à titre d'exemple en relation avec la figure 5A (bus-bars 111 continus perpendiculaires au réseau de doigts 105) et dédiés à l'interconnexion usuelle des cellules à partir de deux à cinq rubans de cuivre. Les métallisations peuvent par exemple présenter des bus-bars de largeurs irrégulières ou des bus-bars discontinus. Les plots conducteurs 17 peuvent être de forme quelconque et sont formés dans les zones de bus continues ou discontinues correspondant aux futurs bus-bars.

La figure 5B est une vue de dessus illustrant de façon schématique un autre exemple de réalisation de métallisations d'une cellule photovoltaïque que celui de la figure 5A. Les bus-bars 111, perpendiculaires aux doigts 105, sont discontinus. Chaque bus-bar 111 est constitué de plusieurs portions 112, chaque portion 112 étant connectée à un ou plusieurs doigts 105. Dans l'exemple illustré en figure 5B, chaque portion 112 est connectée à deux doigts 105. Les portions 112 de chaque bus-bar 111 ne sont pas nécessairement reliées électriquement entre elles lors de la formation des métallisations. Elles le seront après la réalisation des interconnexions avec les rubans de cuivre.

La figure 3B est une vue de dessus correspondant à la figure 3A dans le cas où les zones de bus 11 sont discontinues. Lors de l'étape de formation des motifs conducteurs 5 par impression, on forme au moins un plot conducteur 17 dans chaque portion 12 des zones de bus 11 discontinues.

## Revendications

1. Procédé de formation d'une cellule photovoltaïque comportant un empilement d'au moins deux couches semi-conductrices dopées selon des types de conductivité opposés, comprenant les étapes suivantes :
a) former des premiers motifs (5) en un premier matériau conducteur par impression sur au moins une des faces de l'empilement ;
b) former des deuxièmes motifs (7) en un matériau isolant, par impression sur ladite au moins une des faces de l'empilement, de sorte que le matériau isolant soit en contact avec au moins une partie des surfaces latérales des premiers motifs et de sorte que l'épaisseur des deuxièmes motifs soit inférieure à celle des premiers motifs ; et
c) former au moins un deuxième matériau conducteur (13) par dépôt électrolytique sur au moins les premiers motifs.

2. Procédé selon la revendication 1, comprenant en outre, après l'étape c) de dépôt électrolytique, une étape d) d'élimination des deuxièmes motifs (7).

3. Procédé selon la revendication 1 ou 2, dans lequel, lors de l'étape a), les premiers motifs (5) sont formés par sérigraphie ou par impression directe sans contact.

4. Procédé selon l'une quelconque des revendications 1 à 3, dans lequel, lors de l'étape b), les deuxièmes motifs (7) sont formés par sérigraphie ou par impression par jet d'encre.

5. Procédé selon l'une quelconque des revendications 1 à 4, dans lequel le rapport de l'épaisseur des premiers motifs (5) sur l'épaisseur des deuxièmes motifs (7) est compris entre 1,2 et 2,5.

6. Procédé selon l'une quelconque des revendications 1 à 5, dans lequel, lors de l'étape a), le rapport de forme des premiers motifs (5) est supérieur à 0,5.

7. Procédé selon l'une quelconque des revendications 1 à 6, dans lequel :
- le premier matériau conducteur est choisi dans le groupe comprenant l'argent, le cuivre et l'aluminium ou est un matériau comprenant un élément métallique choisi dans le groupe comprenant l'argent, le cuivre et l'aluminium ;
- et/ou le matériau isolant est une résine organique isolante ;
- et/ou le deuxième matériau conducteur (13) est choisi dans le groupe comprenant l'argent et le cuivre.

8. Procédé selon l'une quelconque des revendications 1 à 7, dans lequel une couche barrière, avantageusement en nickel, est formée par dépôt électrolytique préalablement au deuxième matériau conducteur (13) et dans lequel une couche de surface en un matériau conducteur, avantageusement choisi dans le groupe comprenant l'argent et l'étain, est formée par dépôt électrolytique après le deuxième matériau conducteur (13), de façon à former un empilement de plusieurs couches de matériaux conducteurs.

9. Procédé selon l'une quelconque des revendications 1 à 8, dans lequel, avant l'étape a) de formation des premiers motifs (5), ladite au moins une des faces de l'empilement est recouverte d'une couche conductrice transparente (3).

10. Procédé selon l'une quelconque des revendications 1 à 9, dans lequel, lors de l'étape a), les premiers motifs (5) formés par impression comprennent des lignes conductrices parallèles les unes aux autres, éventuellement espacées les unes des autres à intervalle régulier et avantageusement discontinues.

11. Procédé selon la revendication 10, dans lequel, lors de l'étape b) de formation des deuxièmes motifs (7), on définit des zones de bus (11), éventuellement orientées perpendiculairement aux premiers motifs (5), correspondant à des portions de ladite au moins une des faces de l'empilement non recouvertes par les deuxièmes motifs.

12. Procédé selon la revendication 11, dans lequel, lors de l'étape a), on forme en outre des plots conducteurs (17) par impression sur ladite au moins une des faces de l'empilement, les plots conducteurs étant disposés dans les zones de bus (11).

13. Procédé selon la revendication 12, dans lequel les zones de bus (11) sont discontinues, et dans lequel, lors de l'étape a), on forme au moins un plot conducteur (17) dans chaque portion (12) des zones de bus (11).

14. Procédé selon l'une des revendications 11 à 13, dans lequel les zones de liaison (19) des premiers motifs (5) avec les zones de bus (11) sont plus larges que le reste des premiers motifs.

## Patentansprüche

1. Verfahren zur Bildung einer photovoltaischen Zelle, umfassend einen Stapel von wenigstens zwei Halbleiterschichten, die gemäß entgegengesetzten Leitfähigkeitstypen dotiert sind, umfassend die folgenden Schritte:
a) Bilden von ersten Motiven (5) aus einem ersten leitfähigen Material durch Druck auf wenigstens einer der Flächen des Stapels;
b) Bilden von zweiten Motiven (7) aus einem isolierenden Material durch Druck auf der wenigstens einen der Flächen des Stapels derart, dass das isolierende Material in Kontakt ist mit wenigstens einem Teil der lateralen Oberflächen der ersten Motive und derart, dass die Dicke der zweiten Motive kleiner ist als jene der ersten Motive; und
c) Bilden wenigstens eines zweiten leitfähigen Materials (13) durch elektrolytische Abscheidung auf wenigstens den ersten Motiven.

2. Verfahren nach Anspruch 1, ferner umfassend, nach dem Schritt c) des elektrolytischen Abscheidens, einen Schritt d) des Entfernens der zweiten Motive (7).

3. Verfahren nach Anspruch 1 oder 2, wobei während des Schritts a) die ersten Motive (5) durch Serigraphie oder durch direkten Druck ohne Kontakt gebildet werden.

4. Verfahren nach einem der Ansprüche 1 bis 3, wobei während des Schritts b) die zweiten Motive (7) durch Serigraphie oder durch Druck mittels Tintenstrahl gebildet werden.

5. Verfahren nach einem der Ansprüche 1 bis 4, wobei das Verhältnis der Dicke der ersten Motive (5) zur Dicke der zweiten Motive (7) zwischen 1,2 und 2,5 enthalten ist.

6. Verfahren nach einem der Ansprüche 1 bis 5, wobei während des Schritts a) das Formverhältnis der ersten Motive (5) größer als 0,5 ist.

7. Verfahren nach einem der Ansprüche 1 bis 6, wobei:
- das erste leitfähige Material ausgewählt ist aus der Gruppe umfassend Silber, Kupfer und Aluminium, oder ein Material ist, das ein metallisches Element enthält, ausgewählt aus der Gruppe umfassend Silber, Kupfer und Aluminium;
- und/oder das isolierende Material ein isolierendes organisches Harz ist;
- und/oder das zweite leitfähige Material (13) ausgewählt ist aus der Gruppe umfassend Silber und Kupfer.

8. Verfahren nach einem der Ansprüche 1 bis 7, wobei eine Barriereschicht, vorzugsweise aus Nickel, durch elektrolytische Abscheidung vor dem zweiten leitfähigen Material (13) gebildet wird, und wobei eine Oberflächenschicht aus einem leitfähigen Material, vorzugsweise ausgewählt aus der Gruppe umfassend Silber und Zinn, durch elektrolytische Abscheidung nach dem zweiten leitfähigen Material (13) gebildet wird, derart, dass ein Stapel von mehreren Schichten von leitfähigen Materialien gebildet wird.

9. Verfahren nach einem der Ansprüche 1 bis 8, wobei vor dem Schritt a) des Bildens der ersten Motive (5) die wenigstens eine der Flächen des Stapels mit einer transparenten leitfähigen Schicht (3) bedeckt wird.

10. Verfahren nach einem der Ansprüche 1 bis 9, wobei während des Schritts a) die durch Druck gebildeten ersten Motive (5) zueinander parallele leitfähige Leitungen umfassen, die gegebenenfalls voneinander in einem regelmäßigen Intervall beabstandet und vorzugsweise diskontinuierlich sind.

11. Verfahren nach Anspruch 10, wobei man während des Schritts b) des Bildens der zweiten Motive (7) Buszonen (11) definiert, die gegebenenfalls orthogonal zu den ersten Motiven (5) orientiert sind, entsprechend Bereichen der wenigstens einen der Flächen des Stapels, die nicht durch die zweiten Motive bedeckt sind.

12. Verfahren nach Anspruch 11, wobei man während des Schritts a) ferner leitfähige Kontaktpunkte (17) durch Druck auf der wenigstens einen der Flächen des Stapels bildet, wobei die leitfähigen Kontaktpunkte in den Buszonen (11) angeordnet sind.

13. Verfahren nach Anspruch 12, wobei die Buszonen (11) diskontinuierlich sind, und wobei man während des Schritts a) wenigstens einen leitfähigen Kontaktpunkt (17) in jedem Bereich (12) der Buszonen (11) bildet.

14. Verfahren nach einem der Ansprüche 11 bis 13, wobei die Verbindungszonen (19) der ersten Motive (5) mit den Buszonen (11) größer sind als der Rest der ersten Motive.

## Claims

1. Method for forming a photovoltaic cell comprising a stack of at least two semi-conducting layers doped according to opposite types of conductivity, including the following steps:
a) forming first patterns (5) made of a first conducting material by printing on at least one of the faces of the stack;
b) forming second patterns (7) made of an insulating material, by printing on said at least one of the faces of the stack, such that the insulating material is in contact with at least one part of the lateral surfaces of the first patterns and such that the thickness of the second patterns is less than that of the first patterns; and
c) forming at least one second conducting material (13) by electrolytic deposition on at least the first patterns.

2. Method according to claim 1, moreover including, after step c) of electrolytic deposition, a step d) of elimination of the second patterns (7).

3. Method according to claim 1 or 2, in which, during step a), the first patterns (5) are formed by screen printing or by direct contactless printing.

4. Method according to any of claims 1 to 3, in which, during step b), the second patterns (7) are formed by screen printing or by ink jet printing.

5. Method according to any of claims 1 to 4, in which the ratio of the thickness of the first patterns (5) to the thickness of the second patterns (7) is comprised between 1.2 and 2.5.

6. Method according to any of claims 1 to 5, in which, during step a), the aspect ratio of the first patterns (5) is greater than 0.5.

7. Method according to any of claims 1 to 6, in which:
- the first conducting material is selected from the group including silver, copper and aluminium or is a material including a metallic element selected from the group including silver, copper and aluminium;
- and/or the insulating material is an insulating organic resin;
- and/or the second conducting material (13) is selected from the group including silver and copper.

8. Method according to any of claims 1 to 7, in which a barrier layer, advantageously made of nickel, is formed by electrolytic deposition prior to the second conducting material (13) and in which a surface layer made of a conducting material, advantageously selected from the group including silver and tin, is formed by electrolytic deposition after the second conducting material (13), so as to form a stack of several layers of conducting materials.

9. Method according to any of claims 1 to 8, in which, before step a) of formation of the first patterns (5), said at least one of the faces of the stack is covered with a transparent conducting layer (3).

10. Method according to any of claims 1 to 9, in which, during step a), the first patterns (5) formed by printing include conducting lines parallel to each other, potentially spaced apart at regular interval and advantageously discontinuous.

11. Method according to claim 10, in which, during step b) of formation of the second patterns (7), bus zones (11) are defined, potentially oriented perpendicularly to the first patterns (5), corresponding to portions of said at least one of the faces of the stack not covered by the second patterns.

12. Method according to claim 11, in which, during step a), conducting pads (17) are moreover formed by printing on said at least one of the faces of the stack, the conducting pads being arranged in the bus zones (11).

13. Method according to claim 12, in which the bus zones (11) are discontinuous, and in which, during step a), at least one conducting pad (17) is formed in each portion (12) of the bus zones (11).

14. Method according to one of claims 11 to 13, in which the zones for connecting (19) the first patterns (5) with the bus zones (11) are wider than the remainder of the first patterns.
